# EUROPEAN PATENT SPECIFICATION

(11) **EP 2 116 114 B1**
(45) Date of publication and mention of the grant of the patent: **11.08.2010**
(21) Application number: 07827694.6
(22) Date of filing: 17.09.2007
(51) Int. Cl.: H05K 1/11, H05K 1/00, H05K 3/34

(54) **PRODUCTION PROCESS OF PRINTED CIRCUITS ON WHICH ELECTRONIC COMPONENTS WITHOUT LEADING WIRE ARE SOLDERED**
PRODUKTIONSPROZESS FÜR LEITERPLATTEN, WORAUF ELEKTRONISCHE KOMPONENTEN OHNE ANSCHLUSSLEITUNG AUFGELÖTET WERDEN
PROCESSUS DE FABRICATION DE CIRCUITS IMPRIMÉS SUR LESQUELS SONT BRASÉS DES COMPOSANTS ÉLECTRONIQUES SANS FIL D'ATTAQUE

(30) Priority: 01.02.2007 IT MC20070018
(43) Date of publication of application: 11.11.2009
(73) Proprietor: Cisel S.r.l. - Circuiti Stampati Per Applicazioni Elettroniche, 60022 Castelfidardo (AN) (IT)
(72) Inventor: FIORETTI, Faustino, I-60022 Castelfidardo (AN) (IT)
(74) Representative: Baldi, Claudio
(86) International application number: PCT/IT2007/000642
(87) International publication number: WO 2008/093373

(56) References cited:
- EP-A- 0 482 940
- GB-A- 2 172 441
- JP-A- 57 018 347
- US-B1- 6 414 382
- "INTEGRATED TEST VIA AND PAD DESIGN" IBM TECHNICAL DISCLOSURE BULLETIN, IBM CORP. NEW YORK, US, vol. 34, no. 3, 1 August 1991 (1991-08-01), pages 361-362, XP000210616 ISSN: 0018-8689

## Description

The present patent application relates to a production process of printed circuits on which electronic components without leading wire situated on the opposite side with respect to the circuit printed side are soldered.

It is understood that protection is to be extended also to the circuit obtained with the process of the invention.

The process according to the invention is especially advantageous when the support on which the circuit is printed consists in a thin layer of nonconductive material, such as for example polymide (PI), polyester (PET), polyethylene naphthalate (PEN), polyvinyl fluoride (Tedlar) film, or films marketed with the MYLAR®, KAPTON®, TEDLAR®, TEFLON® trademarks. The aforementioned type of printed circuits is impaired by the problem of making electrical connections between the side on which copper tracks are printed and the opposite side of the support on which the electronic components without leading wire are soldered.

The said connections inevitably require to drill holes on the support in all soldering points of the electronic components; however, this simple operation drilling operation does not guarantee the safe fixing of electronic components by means of tin drops.

It must be noted that in this type of industrial application the most common soldering process is technically defined as "total wave soldering" or "selective wave soldering".

In order to perform wave soldering, the support must be suitably prepared by means of three different operations: the first operation consists in rolling both sides of the support with sheets of copper or any other conductive material, the second operation consists in drilling the laminated support, and the third operation consists in metallising the holes drilled on the laminated support.

The third metallising operation is used to make the electrical connections in each hole, whose walls are covered with conductive material, usually copper, to favour the flow of the tin drop through and over the hole during the wave soldering process of the electronic component.

It must be noted that the metallising operation is carried out by means of a galvanic process that involves high costs and long operating times, as well as severe environmental problems, due to the contamination factors that are generally associated with most chemical processes.

GB 2 172 441 discloses a single-sided printed wiring board comprising through-holes, a conductive pattern covering the through-holes and electronic components mounted in the rear surface of the substrate, in position over the through holes.

IBM Technical disclosure bulletin Vol. 34, n. 3 "INTEGRATED TEST VIA AND PAD DESIGN" discloses a circuit board with surface mounted components to be mounted on dielectric substrates on the pads on the underling levels in the dielectric structure of the substrates.

JP 57 018347 discloses a circuit board wherein holes are formed in the insulating film and electrode patterns are formed with copper foil on the back face of the film.

US 6,414,382 discloses a semiconductor device which does not require solder resist to be applied to the surface.

The purpose of the present invention is to reduce costs, operating times and contamination of the production process of a specific type of printed circuits (preferably on thin supports), on which electronic components without leading wire situated on the opposite side with respect to the circuit printed side are soldered.

The said purpose has been achieved by the process of the invention, which completely eliminates the expensive, long and contaminating metallising process, and uses the rolling process only on one side of the support, with consequent saving on copper.

According to the process of the invention, the support is drilled before - and not after - rolling in such a way that the copper layer used to cover the support during rolling (performed on one side only) covers the opening of all the holes that have been previously drilled in the soldering points of electronic components.

According to the process of the invention, a second drilling operation is performed with punches to drill smaller holes on the copper layer inside the holes that were initially drilled on the support.

During the wave soldering process of the electronic components the smaller holes favour the passage of the tin flow, which goes through and over the holes until it reaches and solders each electronic component located on the opposite side of the support with respect to the side on which tin is introduced in the said holes.

For major clarity the description of the process of the invention continues with reference to the enclosed drawings, which are intended for purposes of illustration only, and not in a limiting sense, whereby:
- figures 1 to 4 illustrate some operating phases of a production process of printed circuits according to the known technique;
- figures 5 to 12 illustrate some operating phases of the process of the invention.

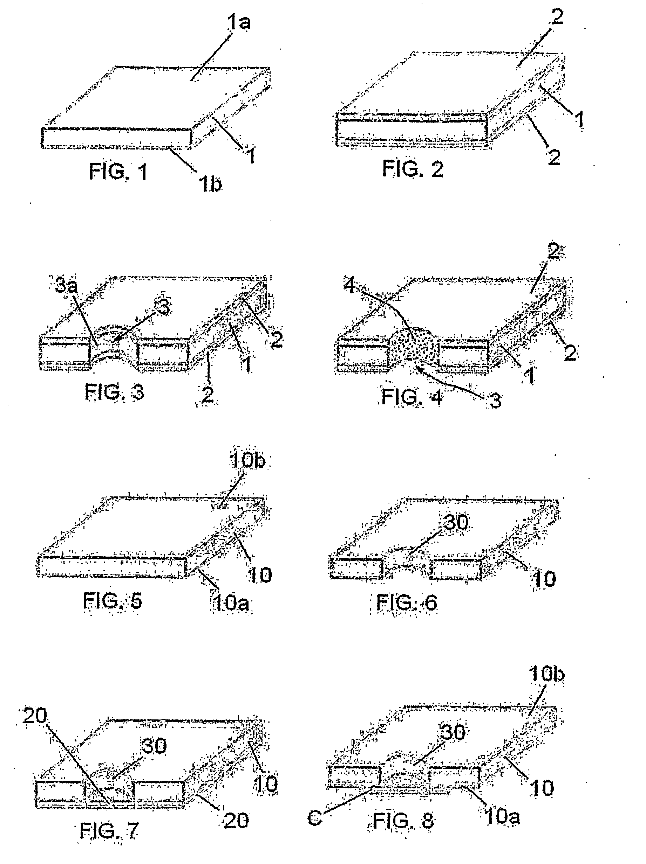

With reference to figures 1 to 4, this description continues by illustrating the different operating phases of the technique.
that is currently used to produce printed circuits on which electronic components without leading wire situated on the opposite side with respect to the circuit printing side are soldered. The current technique provides for the following sequence of operations:
- Rolling of the support (1) on both sides (1 a and 1 b), which are completely and uniformly covered with a layer of copper (2) or other conductive material, as shown in fig. 2;
- Drilling of the laminated support to obtain a series of holes (3) in all soldering points of the electronic components;
- Realisation of circuits by means of photogravure or other suitable known process;
- Metallising of the holes (3) by means of galvanic process, covering the walls (3a) with a layer of conductive material (4) responsible for the electrical connection between the two sides (1 a and 1 b) of the support (1), as shown in fig. 4.

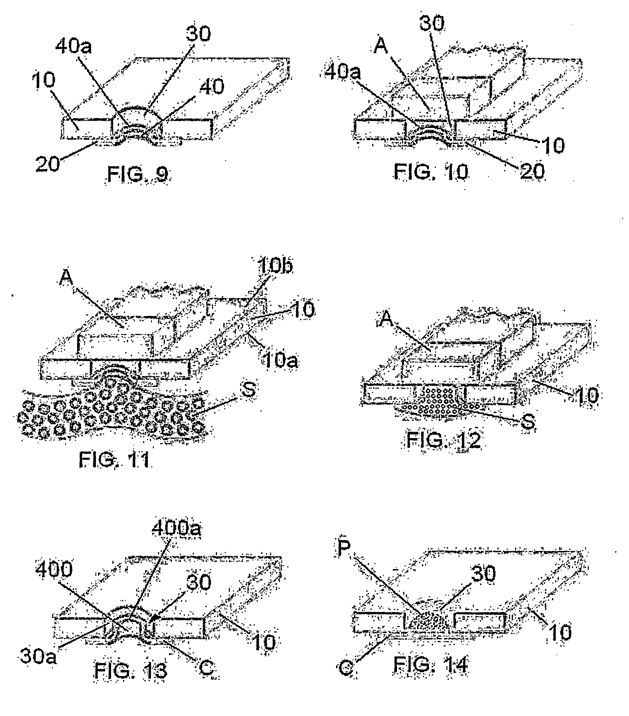

This description continues by illustrating the different operations of the process of the invention, with reference to figures 5 to 10:
a) - drilling of the support (10) to obtain a series of holes (30) in all soldering points of the electronic components, as shown in fig. 6;
b) - rolling of the support (10) only on one (10a) of the two sides (10a and 10b), which is completely and uniformly covered with a layer of copper or other conductive material (20), which covers and closes the opening of all the holes (30), as shown in fig. 7;
c) - realisation of circuits (C) on the side (10a) of the support (10), as shown in fig. 8;
d) - drilling of smaller holes (40) inside the holes (30) on the copper layer (20), as illustrated in fig. 9, which shows that the borders (40a) of the.small holes (40) are folded inwards the larger holes (30).

After preparing the support (10), the electronic component is soldered by placing it on the hole (30), as shown in fig. 10.

Figures 11 to 12 diagrammatically show the wave soldering process of the electronic component (A) on the support (10).

Figures 11 and 12 show that during the wave soldering process of the electronic component (A), tin (S) flows through the small holes (40) until it reaches and solders the electronic component (A) situated on the side (10b) of the support (10) opposite to the side (10a) with the circuits (C).

According to a different embodiment of the process of the invention, the drilling operation d) is performed with punches and dies to obtain a drawn hole (400), whose border (400a) is folded towards the non-laminated side (10b) of the support (10).

This version of the embodiment is advantageous in case of supports (10) that are not thin and rigid, as illustrated in fig. 13, which shows how the folded border (400a) internally covers the lateral walls (30a) of the hole (30).

If the soldering process of the electronic components (A) is performed with soldering paste (P) instead of wave soldering, the aforementioned operation d) is not necessary.

In this case, which is not part of the present invention, operation d) is replaced with the following operation:
d1) deposit of a dose of conductive soldering paste (P) inside the holes (30), as shown in fig. 14.

According to a known technique, the said paste (P) is submitted to REFLOW-oven process in which the paste melts and solders the component (A).

## Claims

1. Production process of printed circuits on which electronic components (A) without leading wire are soldered, comprising the following operations:
a) - drilling of a support (10) to obtain a series of holes (30) in all soldering points of the electronic component (A);
b) - rolling or laminating of the support (10) only on one (10a) of the two sides (10a and 10b), which is completely and uniformly covered with a layer of copper or other conductive material (20), which covers and closes the opening of all the holes (30);
c) - realisation of circuits (C) on the side (10a) of the support (10) covered with the conductive layer,
**characterised by** the fact that
the operation c) is followed by the following operation:
d) - drilling of smaller holes (40) inside the holes (30) on the conductive layer (20), performed with punches and dies to obtain a drawn tapered hole (400), whose border (400a) is folded towards the non-laminated side (10b) of the support (10), in such a way to cover the internal walls (30a) of the hole (30) of the support, and
e) - wave soldering of the electronic component (A) situated on the non-laminated side (10b) of the support (10), by means of soldering alloy (S) flowing through the small holes (40) of the conductive layer (20).

2. Production process of printed circuits as claimed in claim 1, **characterised by** the fact that the support (10) is made of a thin polyamide or polyester film.

3. Production process of printed circuits as claimed in any of the preceding claim, **characterised by** the fact that the support (10) is made of a flexible film.

4. Printed circuit comprising:
- a support (10) provided with holes (30) in all soldering points of the electronic component (A),
- a layer of copper or other conductive material (20) rolled or laminated only on one (10a) of the two sides (10a and 10b) of the support (10),
- circuits (C) realised on the side (10a) of the support (10) covered with the conductive layer (20),
**characterised in that**
said conductive layer (20) is provided with smaller through holes (40) disposed inside said holes (30) of the support,
said small through holes (40) are drawn tapered holes (400), whose border (400a) is folded towards the non-laminated side (10b) of the support (10), in such a way to cover the internal walls (30a) of the hole (30) of the support, and
said printed circuit comprising at least one electronic component (A) without leading wire situated on the non-laminated side (10b) of the support (10), and soldered by wave soldering of soldering alloy (S) which passes through the small holes (40) of the conductive layer (20).

## Patentansprüche

1. Verfahren zur Herstellung von Leiterplatten, auf die elektronische Bauteile (A) ohne Anschlussleitung aufgeschweißt werden sollen, umfassend folgende Arbeitsphasen:
a) - Bohrung des Trägers (10) zur Herstellung einer Reihe von Löchern (30) an allen zuvor festgelegten Lötpunkten des elektronischen Bauteils (A);
b) - Laminierung des Trägers (10) auf nur einer der beiden Seiten (10a und 10b), welche vollständig und gleichmäßig mit einer Schicht aus Kupfer oder einem anderen leitfähigen Material (20) bedeckt wird, welches den Eingang aller Löcher (30) abdichtet und verschließt;
c) - Ausführung der Stromkreise (C) auf der Seite (10a) des Trägers (10), der mit der leitfähigen Schicht bedeckt ist,
**dadurch gekennzeichnet, dass**
auf die Phase c) die nachstehenden Phasen folgen:
d) - Bohrung von kleineren Löchern (40) innerhalb der Löcher (30) in der leitfähigen Schicht (20) mittels Prägestempeln und Gegenstempeln, die in der Lage sind, ein tiefgezogenes Loch (400) anzufertigen, dessen Ränder zur nicht laminierten Seite (10b) des Trägers (10) hin gebogen sind, um die Innenwände (30a) der Löcher (30) des Trägers zu bedecken, und
e) - Wellenschweißung des elektronischen Bauteils (A), das auf der nicht laminierten Seite (10b) des Trägers (10) mittels Lot (S) angebracht wird, das durch die kleineren Löcher (40) der leitfähigen Schicht (20) hindurchfließt.

2. Verfahren zur Herstellung von Leiterplatten gemäß Anspruch 1, **dadurch gekennzeichnet, dass** der Träger (10) aus einem dünnen Film aus Polyamid oder Polyester besteht, wobei vorgesehen ist, dass auf die Phase c) die nachstehende Phase folgt:
d1) Aufbringen einer Dosis Lötpaste (P) im Inneren der Löcher (30).

3. Verfahren zur Herstellung von Leiterplatten gemäß dem vorstehenden Anspruch, **dadurch gekennzeichnet, dass** der Träger (10) aus einem flexiblen Film besteht.

4. Leiterplatte umfassend:
- einen Träger (10) mit Löchern (30) an allen Schweißpunkten der elektronischen Bauteile (A),
- eine Schicht aus Kupfer oder einem anderen leitfähigen Material (20), das nur auf einer (10a) der beiden Seiten (10a, 10b) des Trägers (10) laminiert ist,
- Stromkreise (C), die auf der Seite (10a) des Trägers (10) ausgeführt sind, die mit der leitfähigen Schicht (20) bedeckt ist,
**dadurch gekennzeichnet, dass**
die leitfähige Schicht (20) kleinere durchgehende Löcher (40) aufweist, die in den Löchern (30) des Trägers angebracht sind,
die durchgehenden kleineren Löcher (40) tiefgezogene Löcher (400) sind, deren Ränder (400a) zur nicht laminierten Seite (10b) des Trägers (10) hin gebogen sind, um die Innenwände (30a) der Löcher (30) des Trägers zu bedecken, und
die Leiterplatte mindestens ein elektronisches Bauteil (A) ohne Anschlussleitung aufweist, das auf der nicht laminierten Seite (10b) des Trägers (10) angebracht ist und mittels Wellenschweißung mit Lot (S) angeschweißt wird, welches durch die kleineren Löcher (40) der leitfähigen Schicht (20) hindurchfließt.

## Revendications

1. Processus pour la réalisation de circuits imprimés sur lesquels des composants électroniques (A) démunis de conducteur électrique doivent être soudés, comprenant les phases opérationnelles suivantes :
a) - perçage du support (10) pour réaliser une série de trous (30), en correspondance de tous les points de soudure préfixés du composant électronique (A) ;
b) - laminage du support (10) sur l'une seule (10a) de ses deux faces (10a et 10b), laquelle est complètement et uniformément revêtue moyennant une couche de cuivre ou matériel conducteur divers (20), qui tamponne et ferme l'embouchure de tous les trous (30) ;
c) - réalisation de la circuiterie (C) sur la face (10a) du support (10) recouverte de la couche conductrice,
**caractérisé en ce que**
la phase c) est suivie des phases suivantes :
d) - perçage de trous plus petits (40) dans les trous (30) sur la couche conductrice (20), réalisé avec des poinçons et des contre-poinçons en mesure d'effectuer en trou (400) embouti, dont le bord (400a) résulte plié vers la face non laminée (10b) du support (10), de manière à revêtir les parois internes (30a) des trous (30) du support, et
e) - soudure à la vague du composant électronique (A) disposé sur le côté non laminé (10b) du support (10), moyennant un alliage de soudure (S) qui s'infiltre à travers les trous plus petits (40) de la couche conductrice (20).

2. Processus pour la réalisation de circuits imprimés, selon la revendication 1, **caractérisé en ce que** le support (10) est constitué d'un mince film en polyamide ou polyester.

3. Processus pour la réalisation de circuits imprimés, selon l'une des revendications précédentes, **caractérisé en ce que** le support (10) est constitué d'un film flexible.

4. Circuit imprimé comprenant :
- un support (10) doté de trous (30) sur tous les points de soudure des composants électroniques (A),
- une couche de cuivre ou matériel conducteur divers (20) laminé sur l'une seule (10a) des deux faces (10a, 10b) du support (10),
- circuiterie (C) réalisée sur le côté (10a) du support (10) revêtit de la couche conductrice (20),
**caractérisé en ce que**
la dite couche conductrice (20) prévoit des trous passants plus petits (40) disposés dans les dits trous (30) du support,
les dits trous passants plus petits (40) sont des trous emboutis (400), dont les bords (400a) sont pliés vers le côté non laminé (10b) du support (10), de manière à revêtir les parois internes (30a) des trous (30) du support, et
dit circuit imprimé comprenant au moins un composant électronique (A) démuni de conducteur électrique, disposé sur le côté non laminé (10b) du support (10), et soudé par soudure à la vague moyennant un alliage de soudure (S) qui passe à travers les trous plus petits (40) de la couche conductrice (20).
